# EUROPEAN PATENT APPLICATION

(11) **EP 3 382 507 A1**
(43) Date of publication of application: **03.10.2018**
(21) Application number: 18157820.4
(22) Date of filing: 21.02.2018
(51) Int. Cl.: G06F 3/01, G08B 6/00, H02N 2/02, A63F 13/285

(54) **MULTI-STABLE HAPTIC FEEDBACK SYSTEMS**

(30) Priority: 31.03.2017 US 201715476056
(71) Applicant: Immersion Corporation, San Jose, CA 95134 (US)
(72) Inventor: MOTAMEDI, Mohammadreza, Montreal, Québec H4R 1Z8 (CA); ALGHOONEH, Mansoor, Montreal, Québec H3G 1C2 (CA); KHOSHKAVA, Vahid, Montreal, Québec H2X 3R4 (CA); LEVESQUE, Vincent, Montreal, Québec H2J 2R1 (CA); CRUZ-HERNANDEZ, Juan Manuel, Montreal, Québec H3Z 1T1 (CA); SABOUNE, Jamal, Montreal, Québec H2T 1R2 (CA)
(74) Representative: Hofstetter, Schurack & Partner

(57) **Abstract**

This disclosure relates to haptic feedback systems that include multi-stable materials for providing haptic feedback to a user. Such haptic feedback systems are useful in structural materials, such as elements of wearables or accessories.

## Description

### TECHNICAL FIELD

This disclosure relates to haptic feedback generators, including multi-stable materials for providing haptic feedback to a user. Such haptic feedback generators are useful in structural materials, such as elements of wearables or accessories.

### BACKGROUND

Electronic device manufacturers strive to produce a rich interface for users. Conventional devices utilize visual and auditory cues to provide feedback to a user. In some interface devices, kinesthetic feedback (such as active and resistive force feedback), and/or tactile feedback (such as vibration, texture, and heat), may also be provided to the user. Haptic feedback can provide cues that enhance and simplify the user interface.

Existing haptic devices, when evaluated against power consumption specifications, may not be able to provide a user with acceptable types and levels of haptic effects, and may be overly costly and complex to produce. As a result there is a need to explore new materials to be used in haptic technology to provide ways of providing haptic feedback.

### SUMMARY

Provided herein are haptic feedback generators which include multi-stable materials and actuators, for providing haptic feedback to users, including as elements of wearables or accessory goods.

In embodiments, provided herein are systems capable of generating haptic feedback. Such systems include a multi-stable material configured in a first stable configuration, a first actuator coupled to the multi-stable material which when activated causes the multi-stable material to move from the first stable configuration to at least a second stable configuration and a third stable configuration, thereby generating haptic feedback, and a first actuator activation signal receiver, which upon receipt of a first actuator activation signal, initiates activation of the first actuator.

Also described herein are methods of providing haptic feedback to a user. The methods include receiving a haptic initiation signal from a source, activating a first actuator coupled to a multi-stable material when the haptic initiation signal is received from the source, and providing haptic feedback to the user by moving the multi-stable material from a first stable configuration to at least a second stable configuration and a third stable configuration upon activating the first actuator.

### BRIEF DESCRIPTION OF THE DRAWINGS

The foregoing and other features and aspects of the present technology can be better understood from the following description of embodiments and as illustrated in the accompanying drawings. The accompanying drawings, which are incorporated herein and form a part of the specification, further serve to illustrate the principles of the present technology. The components in the drawings are not necessarily to scale.
FIG. 1 shows a system capable of generating haptic feedback in accordance with an embodiment hereof.
FIGS. 2A-2D show a multi-stable material in accordance with an embodiment hereof.
FIG. 3 shows a plot of energy versus position for an exemplary multi-stable material in accordance with an embodiment hereof.
FIG. 4 shows a sectional view of a multi-stable material taken across line A-A in FIG. 1, in accordance with an embodiment hereof.
FIG. 5A shows an example of an actuator, represented as a shape memory alloy in accordance with an embodiment hereof.
FIG. 5B shows an example of an actuator, represented as a macro fiber composite in accordance with an embodiment hereof.
FIG. 6A shows a system capable of generating haptic feedback associated with a structural material in accordance with an embodiment hereof.
FIGS. 6B-6C show a device incorporating a system capable of generating haptic feedback in accordance with an embodiment hereof.
FIG. 6D shows an additional device incorporating a system capable of generating haptic feedback in accordance with an embodiment hereof.
FIGS. 6E-6H show a watch device incorporating a system capable of generating haptic feedback in accordance with an embodiment hereof.
FIGS. 7A and 7B show systems capable of generating haptic feedback in accordance with embodiments hereof.
FIG. 8 shows a system capable of generating haptic feedback in accordance with an embodiment hereof.
FIG. 9 shows a system capable of generating haptic feedback in accordance with an embodiment hereof.
FIG. 10 shows a system capable of generating haptic feedback in accordance with an embodiment hereof.

### DETAILED DESCRIPTION

The foregoing and other features and aspects of the present technology can be better understood from the following description of embodiments and as illustrated in the accompanying drawings. The accompanying drawings, which are incorporated herein and form a part of the specification, further serve to illustrate the principles of the present technology. The components in the drawings are not necessarily to scale.

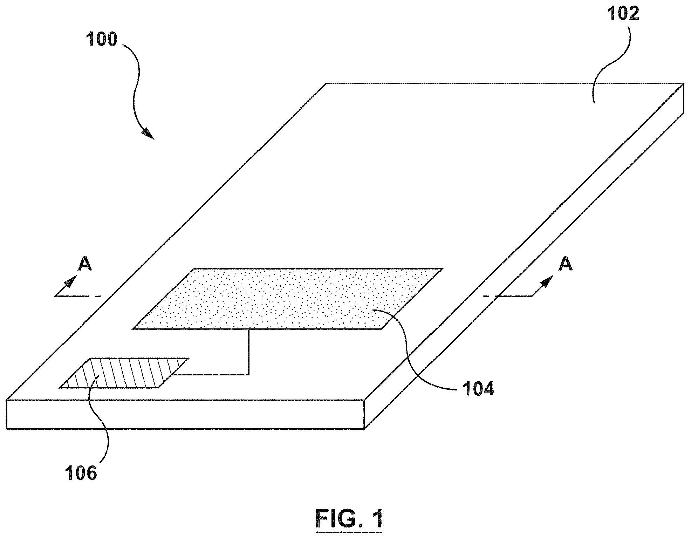

In embodiments, as shown for example in FIG. 1, provided herein is a system 100 for generating or providing haptic feedback to a user.

As used herein "haptic feedback," "haptic feedback signal," or "haptic signal" are used interchangeably and refer to information such as vibration, texture, and/or heat, etc., that are transferred via the sense of touch from a system or haptic feedback generator, as described herein, to a user.

In embodiments, system 100 includes a multi-stable material 102 configured in a first stable configuration (or simply a first stable configuration). System 100 also includes at least one actuator 104 coupled to multi-stable material 102. When activated or actuated, actuator 104 causes multi-stable material 102 to move from the first stable configuration to at least a second stable configuration, and actuator 104 then causes multi-stable material 102 to move to a third stable configuration, thereby generating haptic feedback to a user. System 100 also can include a first actuator activation signal receiver 106 that upon receipt of a first actuator activation signal initiates activation of actuator 104. Actuator activation signal receiver 106 can be any suitable signal receiver and/or processing unit, capable of receiving a signal from an activating signal, from for example, a cell phone, tablet, computer, car interface, game console, etc., and translating that signal to in turn activate or actuate actuator 104.

As used herein "multi-stable" and "multi-stable materials" refers to the property of a material to exist in at least three distinct, stable configurations, with each stable configuration being at a minimum energy between an energy inflection point. The property to exist in the at least three distinct stable configurations is not an inherent property of the material, but results from the process by which the multi-stable materials are formed.

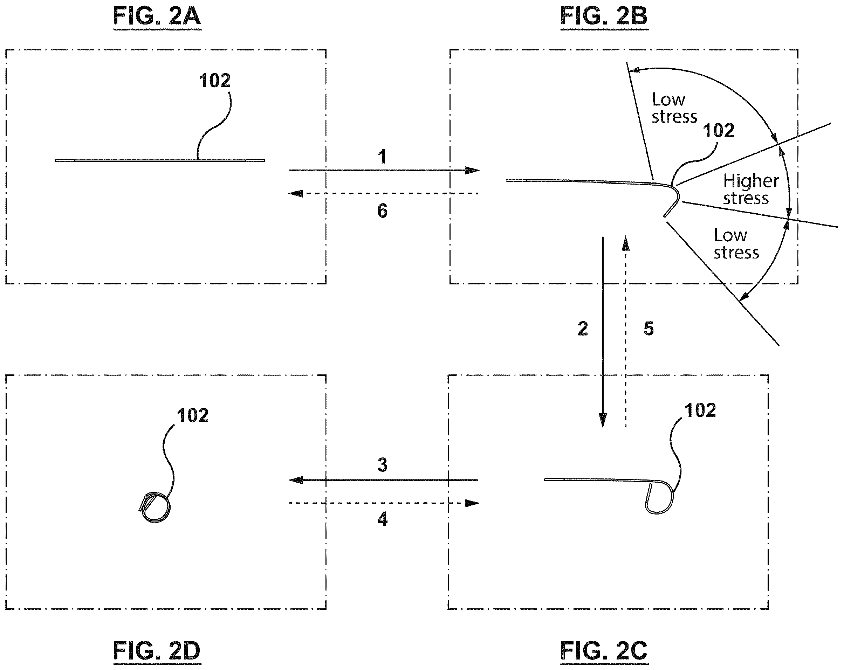

As illustrated for an exemplary multi-stable material in FIGS. 2A-2D, multi-stable material 102 is in a first stable configuration or position in FIG. 2A, e.g., as a flat band or strip. The multi-stable material upon actuation via actuator 104, as described herein, can then move to a second stable configuration or position, as shown in FIG. 2B, designated as action 1. As shown in FIG. 2B, in some embodiments, the multi-stable material exhibits varying stress points (high or low structural stress in the material) or sections within the material. Upon further actuation, multi-stable material 102 suitably moves to a third stable configuration or position as shown in FIG. 2C, for example via action 2. In additional embodiments, further actuation via actuator 104 suitably causes multi-stable material 102 to move to a fourth stable configuration or position as shown in FIG. 2D, for example via action 3. As shown in FIGS. 2A-2D, the actuator can be configured in such a way so that the movement of the multi-stable material is reversible, that is following actions 4, 5 and 6 to return from the fourth stable configuration or position, back to the third, second, and ultimately the first, stable configurations or positions. It is also possible to stop or maintain the multi-stable material at any of the intermediate stable positions between the fourth and first multi-stable positions during either the forward actuation, or the reversal. In additional embodiments, more than four stable configurations or positions (e.g., five, six, seven, eight, nine, ten, etc.) can be configured from multi-stable material 102, such that actuator 104 coupled to the multi-stable material causes the multi-stable material to move from a third stable configuration to at least a fourth stable configuration, a fifth stable configuration, a sixth stable configuration, and so on.

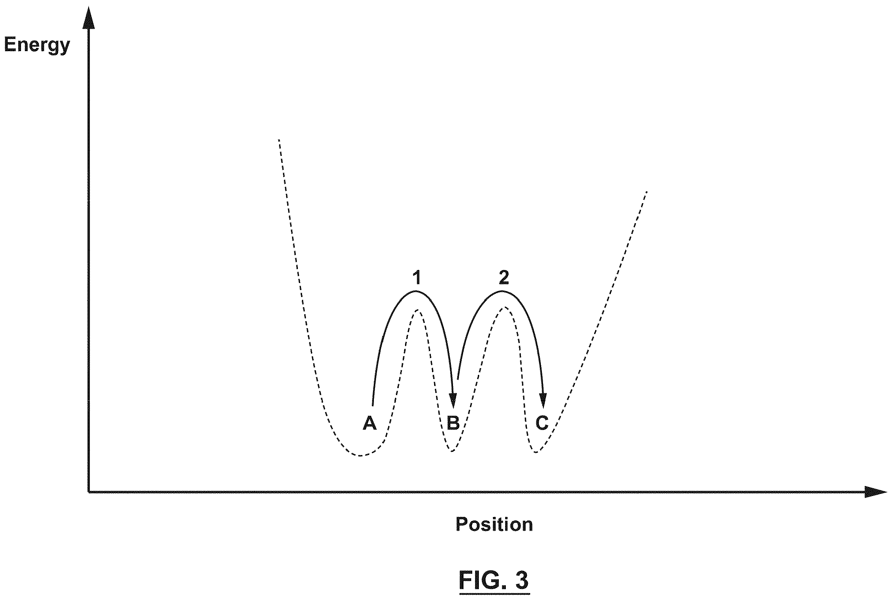

FIG. 3 shows a potential energy diagram for an exemplary multi-stable material 102 as described herein. As demonstrated, the exemplary multi-stable material begins at an initial stable position A, which upon actuation, moves along energy path 1, over a potential energy barrier, to a second stable position B. Upon further actuation, the multi-stable material moves over an additional potential energy barrier, along path 2, to the third stable position C.

As described herein, multi-stable material 102 can be made of a metal, or a polymer composite. Multi-stable materials can be fabricated to undergo a fast deformation when activated with a small amount of force (actuation or activation force). In embodiments, carbon fibers are oriented in layers (suitably carbon fibers embedded in a polymer matrix), to achieve an anisotropic structure. For example, an epoxy-carbon structure composite can be prepared by impregnating or dispersing carbon fibers, carbon sheets, carbon filaments, carbon nanotubes, carbon nanostructures, etc., in an epoxy. The carbon structures can then be oriented in the desired direction using conventional techniques such as various flow or mixing techniques. The epoxy can then be cured, for example under high pressure, to create the multi-stable material comprising the epoxy-carbon composite structure. Multi-stable materials and structures can also be made of metals (e.g., beryllium-copper), polymer composites (carbon fiber, fiber glass, etc.) and shape memory polymers (SMP). Multiple layers of materials (e.g., 3, 4, 5, 6, 7, 8, 9, 10, etc.) of polymers and/or metals, can be arranged to create multi-stable materials as described herein.

Actuator 104 for use in the systems described herein can be a smart material actuator, such that the actuator is capable of being controlled such that the response and properties of the actuator change under a stimulus. Actuators 104 are generally capable of reacting to stimuli or the environment in a prescribed manner to provide a specified actuation. Exemplary actuators 104, including smart material actuators, may include a shape memory material alloy (SMA), a shape memory polymer (SMP), an electroactive polymer (EAP), and a macro fiber composite (MFC). Additional actuators, beyond smart material actuators, can also be used, and can include for example, motors such as DC or geared motors, relays, eccentric rotating mass (ERM) motors and linear resonant actuators (LRA), etc.

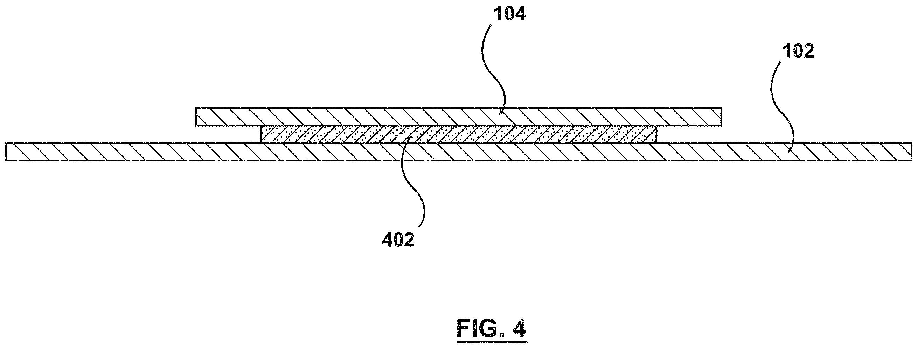

Methods of coupling or associating actuator 104 to multi-stable material 102 include use of various adhesives and glues, mechanical mechanisms such as staples or tacks, soldering, co-melting, etc. For example, as shown in FIG. 4, actuator 104 can be bound to multi-stable material 102 via bonding mechanism 402, which in embodiments, can be a flexible adhesive or other bonding material.

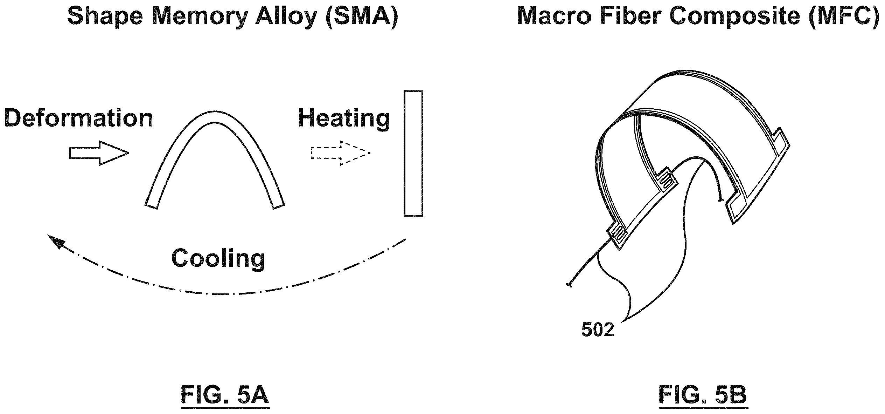

Actuator 104 can be a shape memory alloy, which as shown in FIG. 5A, refers to a metallic alloy which can be processed such that the actuator may undergo a reversible shape change in response to heating and cooling. Exemplary types of shape-memory alloys are copper-aluminum-nickel, and nickel-titanium (NiTi) alloys, or can be the result of alloying zinc, copper, gold and iron. SMAs can generally be processed to exist in two different phases, with three different crystal structures (i.e. twinned martensite, detwinned martensite and austenite) and six possible transformations. Shape memory alloys obtain their properties as a result of processing of the materials. Shape-memory alloys are typically made by casting, using vacuum arc melting or induction melting. These are special techniques used to keep impurities in the alloy to a minimum and ensure the metals are well mixed. The ingot is then hot rolled into longer sections, which can be then prepared into a wire. The way in which the alloys are "trained" depends on the desired properties. The "training" dictates the shape that the alloy will remember when it is heated. This occurs by heating the alloy so that the dislocations re-order into stable positions, but not so hot that the material recrystallizes. For example, they are heated to between 400 °C and 500 °C for 30 minutes, shaped while hot, and then are cooled rapidly by quenching in water or by cooling with air.

Macro fiber composites (MFC) can be adapted for use as actuators 104 as described herein, an MFC actuator in accordance with embodiments hereof suitably includes rectangular piezo ceramic (suitably ribbon-shaped) rods sandwiched between layers of adhesive, electrodes and polyimide film that are formed into a thin conformable sheet. The electrodes are attached to the film in an interdigitated pattern which transfers the applied voltage from the MFC directly to and from the ribbon-shaped rods. This assembly enables in-plane poling, actuation and sensing in a sealed and durable, ready to use package. Such a MFC actuator that is formed as a thin, surface conformable sheet can be applied (normally bonded) to various types of structures or embedded in a composite structure, such as the multi-stable materials described herein. If voltage is applied the MFC will bend or distort materials, counteract vibrations or generate vibrations. If no voltage is applied the MFC can work as a very sensitive strain gauge, sensing deformations, noise and vibrations. The MFC actuator is also an excellent device to harvest energy from vibrations. An exemplary macro fiber composite which can be used as actuator 104 is shown in FIG. 5B, demonstrating the flexibility of the MFC actuator. Power leads 502 are also shown.

In additional embodiments, actuator 104 is comprised of or formed from a shape memory polymer (SMP), which allows programing of the polymer providing it with the ability to change shape from a first to a second shape.

The shape-memory effect is not an intrinsic property, meaning that polymers do not display this effect by themselves. Shape memory results from a combination of polymer morphology and specific processing and can be understood as a polymer functionalization. By conventional processing, e.g. extruding or injection molding, the polymer is formed into its initial, permanent shape B. Afterwards, in a process called programming, the polymer sample is deformed and fixed into the temporary shape A. Upon application of an external stimulus, the polymer recovers its initial permanent shape B. This cycle of programming and recovery can be repeated several times, with different temporary shapes in subsequent cycles. Shape-memory polymers can be elastic polymer networks that are equipped with suitable stimuli-sensitive switches. The polymer network consists of molecular switches and net points. The net points determine the permanent shape of the polymer network and can be a chemical (covalent bonds) or physical (intermolecular interactions) nature. Physical crosslinking is obtained in a polymer whose morphology consists of at least two segregated domains, as found for example in block copolymers. Additional information and examples of SMPs can be found in Shape Memory Polymers, MaterialsToday, Vol. 10, pages 20-28 (April 2007), the disclosure of which is incorporated by reference herein in its entirety.

Transformation of SMPs from one or a first configuration to another or a second configuration is suitably controlled by controlling the temperature of the SMP in relation to its glass transition temperature (Tg). Raising the temperature of the SMP by heating it above its Tg, will cause the SMP actuator to transition to its second (memorized or original) configuration, resulting in activation or actuation of the multi-stable material and moving or transforming from a first stable configuration to a second stable configuration, and suitably to a third (and fourth, fifth etc., if desired) stable configuration. Exemplary shape memory polymers include various block copolymers, such as various poly(urethanes), poly(isoprene) and poly(ether esters), which have been programmed to have the required shape memory characteristics.

Actuator activation signal receiver 106 can include various components and electronics for receiving a signal, modifying that signal if needed, and in turn actuating or activating actuator 104 to cause multi-stable material 102 to move between the various stable configurations. Actuator activation signal receiver 106 can also include various power sources, or such power sources can be directly associated with actuator 104, if desired.

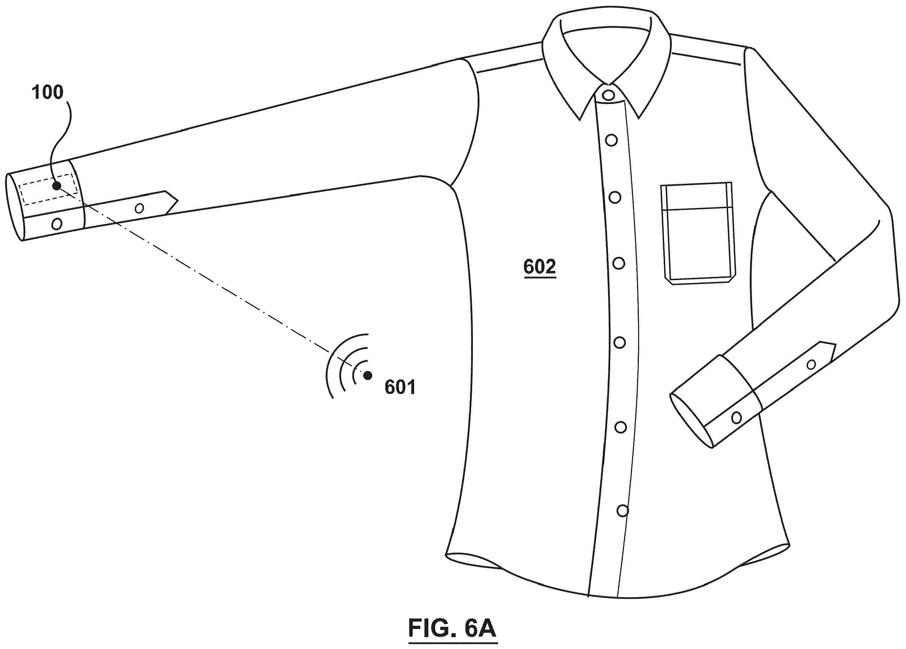

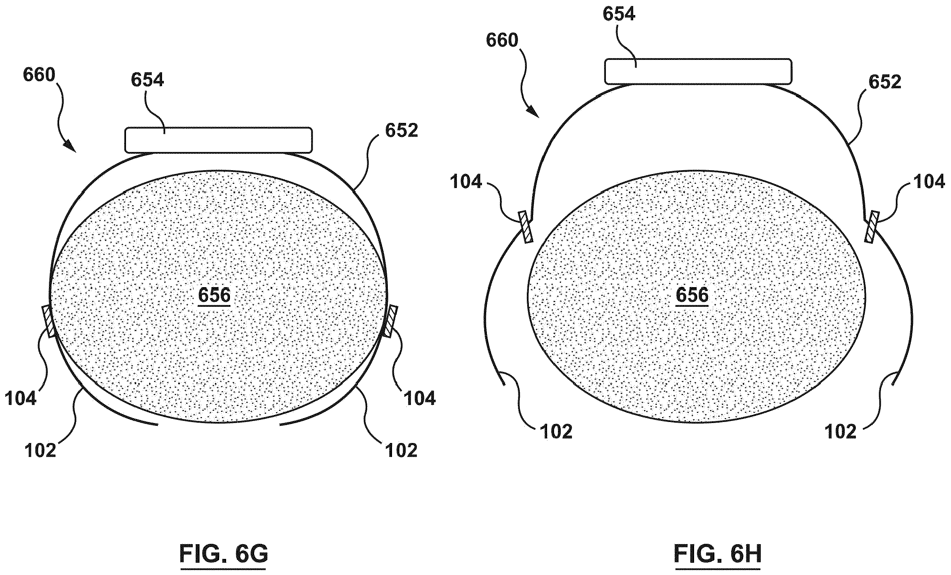

In embodiments, the systems described herein can be associated with or part of a structural material 602, for example as shown in FIG. 6A illustrating the use of system 100 associated with a dress shirt.

As used herein, "structural material" means a material used in constructing a wearable, personal accessory, luggage, etc. Examples of structural materials include: fabrics and textiles, such as cotton, silk, wool, nylon, rayon, synthetics, flannel, linen, polyester, woven or blends of such fabrics, etc.; leather; suede; pliable metallic such as foil; Kevlar, etc. Examples of wearables include: clothing; footwear; prosthetics such as artificial limbs; headwear such as hats and helmets; athletic equipment worn on the body; protective equipment such as ballistic vests, helmets, and other body armor. Personal accessories include: eyeglasses; neckties and scarfs; belts and suspenders; jewelry such as bracelets, necklaces, and watches (including watch bands and straps); wallets, billfolds, luggage tags, etc. Luggage includes: handbags, purses, travel bags, suitcases, backpacks, including handles for such articles, etc.

Various mechanisms for associating system 100 (to include multi-stable material 102, actuator 104 and actuator activation signal receiver 106) to structural material 602 can be used. For example, system 100 can be integrated into structural material 602. For instance, system 100 can be made part of structural material 602 during formation of structural material 602, such as by weaving or sewing the system 100 into the structure of a textile, etc.

In additional embodiments, system 100 can be fixedly attached to structural material 602. In such embodiments system 100 can be glued, taped, stitched, adhered, stapled, tacked, or otherwise attached to structural material 602. System 100 can also be integrated into, or on, various substrates, e.g., polymers such as rubbers, silicones, silicone elastomers, Teflon, plastic poly(ethylene terephthalate), etc., in the form of patches, ribbons or tapes that can then be attached to structural material 602 (e.g., adhered or sewn). Such embodiments allow system 100 to be easily removed and used on more than one structural material, for example, transferring from one wearable article to another.

In additional embodiments, system 100 (as shown in FIG. 1) can be enclosed in an encapsulating material, suitably a water-resistant material or polymer, allowing for system 100 to come into contact with water, such as during washing of a wearable, or during wearing of a wearable article where water may be present. Exemplary materials for use as encapsulating materials include various polymers, such as rubbers, silicones, silicone elastomers, Teflon, plastic poly(ethylene terephthalate), etc.

In embodiments, as shown in FIG. 6A, an external signal 601, e.g., a cell phone or other signal initiating device (computer, tablet, car, etc.), can provide an activation signal to actuator activation signal receiver 106 of system 100, which actuates or activates actuator 104 to cause multi-stable material 102 to move from one stable confirmation to a second and/or third stable confirmation, as described herein. This movement provides the haptic feedback to a user, for example, a person wearing a structural material, such as the dress shirt shown in FIG. 6A.

Exemplary external signals 601 can be from a cellular phone, tablet, computer, car interface, smart device, game console, etc., and can indicate for example the receipt of a text message or e-mail, phone call, appointment, etc.

In further embodiments, a controller is also suitably included to provide an interface between an external device and the systems, as described herein. Components of a controller are well known in the art, and suitably include a bus, a processor, an input/output (I/O) controller and a memory, for example. A bus couples the various components of controller, including the I/O controller and memory, to the processor. The bus typically comprises a control bus, address bus, and data bus. However, the bus can be any bus or combination of busses suitable to transfer data between components in the controller.

A processor can comprise any circuit configured to process information and can include any suitable analog or digital circuit. The processor can also include a programmable circuit that executes instructions. Examples of programmable circuits include microprocessors, microcontrollers, application specific integrated circuits (ASICs), programmable gate arrays (PGAs), field programmable gate arrays (FPGAs), or any other processor or hardware suitable for executing instructions. In the various embodiments, the processor can comprise a single unit, or a combination of two or more units, with the units physically located in a single controller or in separate devices.

An I/O controller comprises circuitry that monitors the operation of the controller and peripheral or external devices. The I/O controller also manages data flow between the controller and peripherals or external devices. Examples of peripheral or external devices with the which I/O controller can interface include switches, sensors, external storage devices, monitors, input devices such as keyboards, mice or pushbuttons, external computing devices, mobile devices, and transmitters/receivers.

The memory can comprise volatile memory such as random access memory (RAM), read only memory (ROM), electrically erasable programmable read only memory (EEPROM), flash memory, magnetic memory, optical memory or any other suitable memory technology. Memory can also comprise a combination of volatile and nonvolatile memory.

The memory is configured to store a number of program modules for execution by the processor. The modules can, for example, include an event detection module, an effect determination module, and an effect control module. Each program module is a collection of data, routines, objects, calls and other instructions that perform one or more particular task. Although certain program modules are disclosed herein, the various instructions and tasks described for each module can, in various embodiments, be performed by a single program module, a different combination of modules, modules other than those disclosed herein, or modules executed by remote devices that are in communication with the controller.

In embodiments described herein, the controller, which can include a wireless transceiver (including a Bluetooth or infrared transceiver), can be integrated into systems 100 or separate from the systems. In further embodiments, the controller can be on a separate device from the systems, but is suitably connected via a wired or more suitably a wireless signal, so as to provide external signal 601 to the various components of the systems and materials described herein.

For example, the controller can provide external signal 601 to actuator drive circuit, which in turn communicates with actuator activation signal receiver 106 or a power source, of the systems described herein, so as to provide haptic feedback to a user of the system as described herein. For example, desired haptic feedback can occur, for example, when a mobile phone or other device to which a controller is paired via wireless connection receives a message or email. Additional examples include a controller being associated with devices such as game controllers, systems or consoles, computers, tablets, car or truck interfaces or computers, automated payment machines or kiosks, various keypad devices, televisions, various machinery, etc. In such embodiments, the controller suitably provides external signal 601 to an actuator drive circuit, to provide haptic feedback to a user in response to a signal originated by or from an external device. The device can also be a part of the wearable on which the various components of the systems described herein are contained. Exemplary feedback or signals that can be provided by a device, include, for example, indications of incoming messages or communication from a third party, warning signals, gaming interaction, driver awareness signals, computer prompts, etc.

In further embodiments, the components described herein can be integrated with or be part of a virtual reality or augmented reality system. In such embodiments, the multistable materials can provide haptic feedback to a user as he or she interacts with a virtual or augmented reality system, providing responses or feedback initiated by the virtual reality or augmented reality components and devices.

In embodiments, actuator 104 can comprise two or more (e.g., three, four, five, etc.) separate actuators working together to cause multi-stable material 102 to move, or transform, from one stable configuration to another. In further embodiments, system 100 can further comprise a second actuator, such that two actuators 104 are coupled to multi-stable material 102 which, when activated, causes multi-stable material 102 to move from an at least third stable configuration to the second and/or the first stable configuration (i.e. a reversal of the movement between stable configurations). In embodiments, system 100 can also include a second actuator activation signal receiver, which upon receipt of a second actuator activation signal, initiates activation of the second actuator to cause the movement described herein.

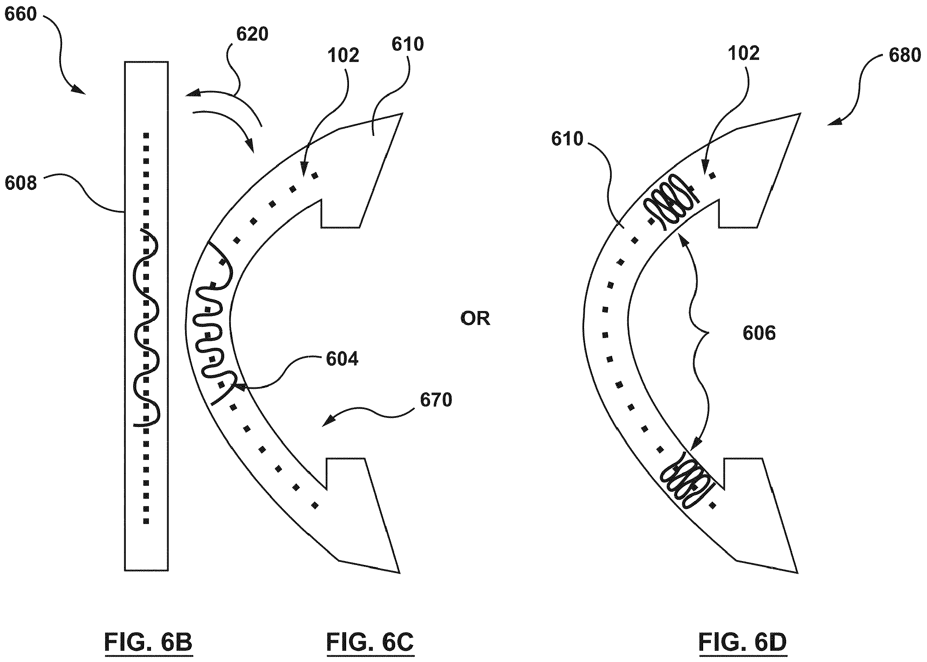

FIG. 6C shows a further embodiment as described herein, where a system 610, which includes multi-stable material 102 and an SMP actuator 604 comprised of a shape memory alloy, has been integrated with or into a device 660. A first stable configuration 608 is shown in FIG. 6B, in which multi-stable material 102 is in a substantially flat configuration. Upon actuation of shape memory alloy actuator 604, the multi-stable material moves to at least a second and then a third stable configuration, providing haptic feedback 620 to a user in the form of a modification of the shape of device 624. FIG. 6C is illustrated as a telephone receiver, for example, moving from a flat configuration (608) (shown in FIG. 6B) to a curved configuration 626 upon receiving an incoming telephone call, and thus providing a haptic feedback to a user, indicating for example that a call is being received.

FIG. 6D shows a similar embodiment wherein a system 610 has been integrated into a device 628. In FIG. 6C, multi-stable material 102 is associated with two SMP actuators 606, each of which is comprised of a shape memory polymer. Device 628 is capable of changing configuration in a similar manner to that shown in FIG. 6B for device 624.

As shown in FIGS. 6C and 6D, the various actuators described herein, including SMAs and SMPs, can be incorporated at various positions within the different systems, depending on the shape and confirmation of the multi-stable material, and the desired use or final confirmation that the multi-stable material will have.

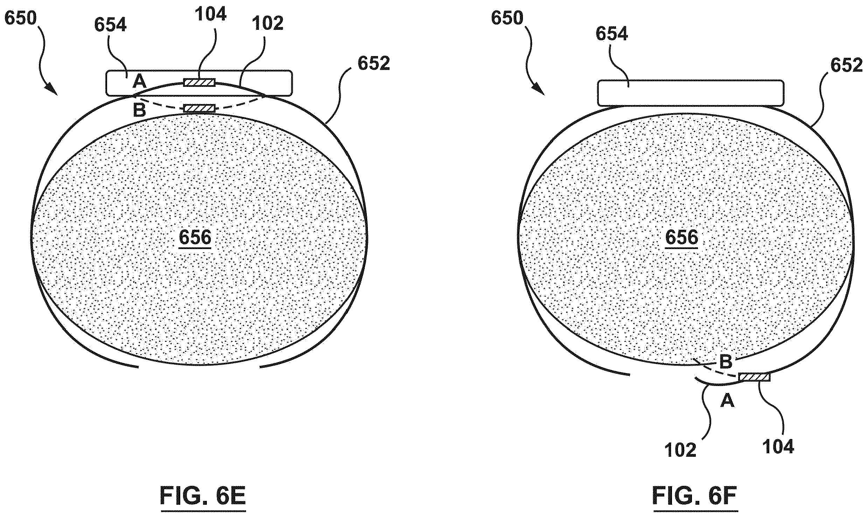

FIG. 6E shows a further embodiment, where a system 650, which includes multistable material 102 and actuator 104, are integrated into or associated with watchband or strap 652, for use with watch 654, which can include both traditional watches, as well as smart watches and other small electronic devices that can be worn on the wrist, for example, mobile devices, etc. As shown in FIG. 6E, in such embodiments, smart material 102 can be in position A, in which the material is pressed against the back of watch 654, or contained within or part of the structure of watch 654. Upon actuation of actuator 104, multistable material 102 moves to position B, in which the multistable material 102 is pressed against a wrist or arm 656 of the user, thereby providing a tight fit or compression fit, to keep watch 654 and watchband or strap 652 attached to the user. Actuation of actuator 104 and movement of multistable material 102 can also provide haptic feedback to a user in the form of pressure, vibration or contact at this position on the user (i.e., the top of the arm or wrist), signaling, for example, an e-mail, alarm or other notification provided by watch 654, or a signal from another external device.

Mutistable material 102 and actuator 104 can also be integrated or associated with watchband or strap 652 at other positions, for example, as shown in FIG. 6F. In such embodiments, actuation of actuator 104 and movement of multistable material 102 from position A to position B can provide haptic feedback in the form of pressure, vibration, or contact, at this position on the user (i.e., the bottom of the wrist or arm). Other placements of multistable material 102 and actuator 104 can also be used to provide haptic feedback to a user of a device as shown in FIGs. 6E-6F.

FIGs. 6G-6H show a further embodiment, where a system 660, which includes multistable material 102 and actuator 104, are integrated into or associated with watchband or strap 652, for use with watch 654, which can include both traditional watches, as well as smart watches and other small electronic devices that can be worn on the wrist, for example, mobile devices, etc. As shown in FIG. 6F, in such embodiments, two sections of smart material 102 can be associated with watch band or strap 654, each including actuators 104. In further embodiments, a single section of smart material 102 can also be used. Upon actuation of actuator 104, multistable material 102 moves between a position shown in FIG. 6F (in which watch band or strap 654 is pressed against a wrist or arm 656 of the user, thereby providing a tight fit or compression fit, to keep watch 654 and watchband or strap 652 attached to the user) to the position shown in FIG. 6G, where the watchband or strap is opened, allowing for removal of the system (and the reverse for putting on the watch). Thus, in such embodiments, system 660 functions as a hinge structure, with the ability to change between the two positions for taking on and off watch 654 (or other similar device or structure). Such a hinge structure can be used in other configurations with the watch, as well as in other devices and accessories, including bracelets, necklaces, rings, etc.

The various systems described herein allow for different devices to move or deform between multiple stable configurations upon activation by external signals, but generally without input from a user. For example a wearable, such as a watch-band or bracelet, can be automatically adjusted to fit a user's arm, and if desired, provide haptic feedback in the form of further movement (i.e., poke, movement, difference in pressure, pinch, etc. to a user's skin surface) in response to an actuation signal, e.g., a phone call, e-mail, text, etc.

In further embodiments, the various systems described herein can be implemented in devices such as portables, including phones, tablet covers, or laptop screens. The systems, through an actuation signal, can transform from one stable configuration to another without user input, for example, devices can move from a storage position into a position to allow a user to watch a movie or video, or take a telephone call.

The various systems described herein can also be used to provide feedback to an external device from a user in an interactive manner. For example, a user can interact with multistable material 102 to move the multistable material 102 through its various stable positions, and in doing so, provide feedback to an external device related to the interaction. For example, a user can interact with multistable material 102, moving the material from a first stable position to a second stable position, thereby signally (for example through a wireless controller and signal) to an external device, that a first (of potentially several) action has been completed.

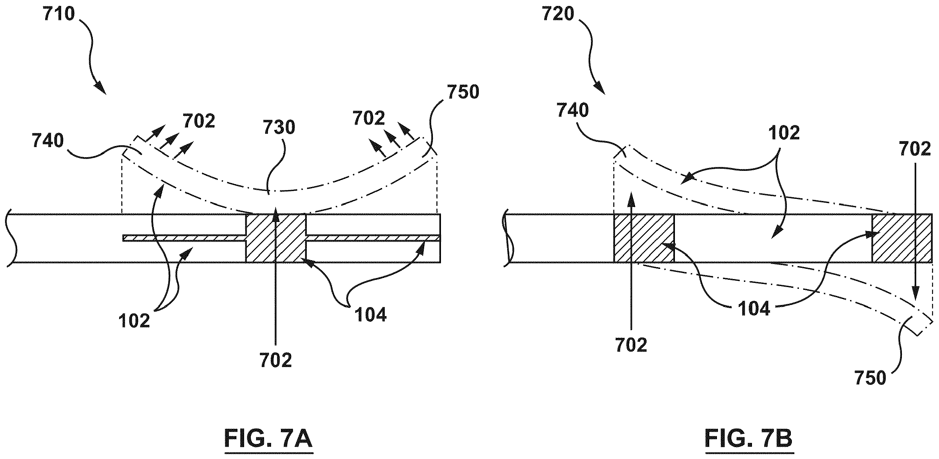

In a further exemplary embodiment in FIG. 7A, a system 710 which includes multi-stable material 102 and actuator 104, is shown moving or transforming from a first stable configuration (flat) to a configuration in which haptic feedback 702 can be provided to a user. As illustrated, placement of actuator 104, which can include two separate actuators, for example one actuator positioned at a location in the middle of multi-stable material, and a second actuator placed along a length of the material, for example as a strip or ribbon of material. The positioning and number of actuators desired or required are dependent upon the desired feedback and application, as well as the size and orientation of the multi-stable material.

As shown in FIG. 7A, in embodiments, at the ends 740, 750 of multi-stable material 102, haptic feedback can be provided by a curving (for example, a bracelet or band, etc., curving away or toward a user), while additional haptic feedback 702 can also be provided near a central portion 730 of system 710, as a pressure point for example against a user, or in some embodiments, by moving contact away from a user.

In further embodiments in FIG. 7B, a system 720 is shown which includes multi-stable material 102 and actuator 104, suitably two actuators, positioned near opposite ends 740, 750 of system 720. Haptic feedback 702 can be provided by transforming or moving multi-stable material 102 in such a way that the ends 740, 750 move to additional stable configurations, thereby providing the haptic feedback to a user, for example in the form of a movement of a structural material, wearable, or other type of device, the manner shown. FIG. 7B shows an embodiment where a first actuator, positioned at or near end 740, can cause the multi-stable material to move in a direction shown by the arrow (e.g., up) representing haptic feedback 702, while a second actuator, position at or near end 750, can cause the multi-stable material to move in a direction shown by the arrow (e.g., down) representing haptic feedback 702. The movements can occur at the same time, or independently, resulting in different stable configurations for the multi-stable material.

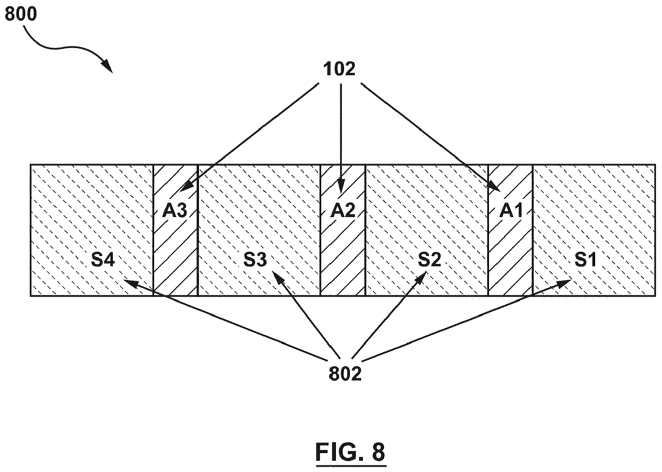

FIG. 8 shows an example of a system 800 where a substrate material 802 (i.e., sections S 1-S4) are connected or joined by multi-stable material 102 (i.e., sections A1-A3). In such an embodiments, multi-stable materials 102 can act as hinges or multi-stable connections points, which when activated resulting in system 800 that can transform between multiple stable configurations, and back again, stopping at intermediate configurations if desired. As used herein "substrate material" 102 refers to a material that is not, by itself, multi-stable, but when connected with multi-stable materials, will be able to deform as described herein. Substrate materials include, for example, various polymers, metals, ceramics, plastics, etc. In additional embodiments, substrate material 802 can have sections of multi-stable material 102 placed overtop of the substrate material, rather than join separate sections of the substrate material, to result in the system shown in FIG. 8.

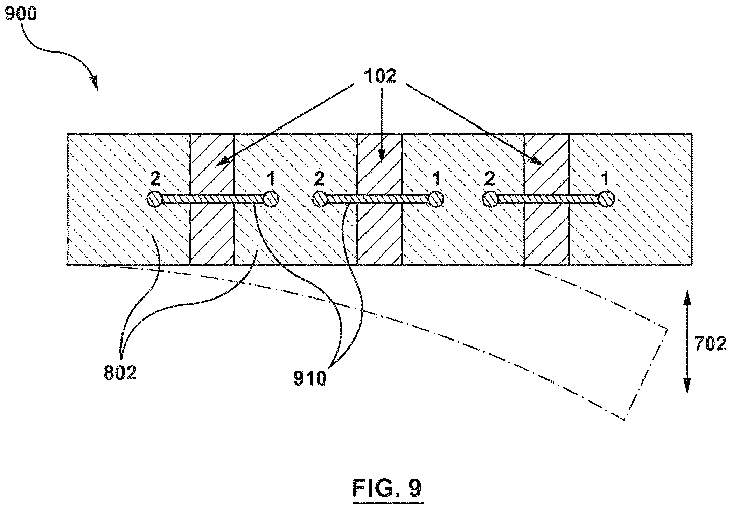

An additional system 900 is shown in FIG. 9, where separate sections of multi-stable material 102, again connect or join substrate material 102 sections. In the embodiment of FIG. 9, hinges 910, which can be, for example, shape memory alloys or an electroactive polymer, allow for movement of system 900 upon actuation, for example from an applied voltage. In response to the actuation, hinges 910 deform system 900 by deforming multi-stable material 102 sections, such that it is able to provide haptic feedback 702 in the form of a deflection of the material to an additional stable conformation. Hinges 910, connected for example as shown at a first (1) and second (2) positions, allow for the tilting or pivoting of multi-stable material 102 to deform between stable configurations. In additional embodiments, substrate material 802 can have sections of multi-stable material 102 placed overtop of the substrate material, rather than join separate sections of the substrate material, to result in the system shown in FIG. 9.

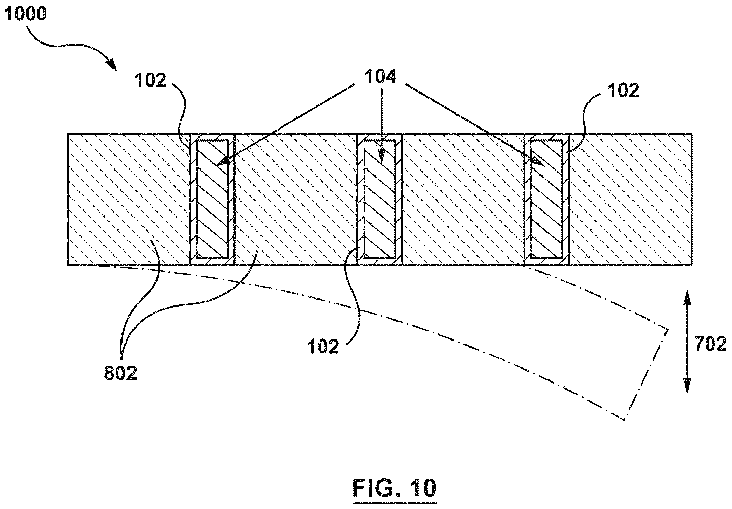

A further system 1000 is shown in FIG. 10, where separate sections of multi-stable material 102, again connect or join substrate material 802. In additional embodiments, substrate material 802 can have sections of multi-stable material 102 placed overtop of the substrate material, rather than join separate sections of the substrate material, to result in the system shown in FIG. 10. In embodiments as shown in FIG. 10, individual actuators 104 can be placed on or in association with multi-stable material 102 sections, allowing for activation of the individual sections. This actuation, allows for movement to achieve haptic feedback 702. Exemplary actuators which can be used in the embodiment shown in FIG. 10 are described herein.

Also provided herein are methods of providing haptic feedback to a user. In embodiments, the methods comprise receiving a haptic initiation signal from a source. As described herein, this source can be a mobile phone, computer, car interface, etc. A first actuator coupled to a multi-stable material is activated when the haptic initiation signal is received from the source. The terms "activated" and "actuated" are used interchangeably herein to indicate that an actuator acts on a multi-stable material to initiate movement or transformation of the material. Haptic feedback is then provided to the user by moving the multi-stable material from a first stable configuration to at least a second stable configuration and a third stable configuration, upon activating the first actuator.

As described throughout, multi-stable materials for use in the methods can be made of a metal or a polymer composite. In embodiments, the multi-stable materials are associated with structural materials, including various wearables, such that the methods described herein result in haptic feedback to users via wearables.

Exemplary actuators for use in the methods are described throughout and suitably include smart material actuators, such as shape memory material alloys (SMA), shape memory polymers (SMP), electroactive polymers (EAP) and macro fiber composites (MFC), coupled to the multi-stable material.

In embodiments, the methods provide for a reversible movement of the multi-stable material, and can include movement of the multi-stable material from a third stable configuration to a fourth, fifth, sixth, etc., stable configuration.

As described herein, two or more separate actuators can be used to activate the multi-stable materials in the various methods described herein. In certain embodiments, a second actuator can be coupled to the multi-stable material which when activated causes the multi-stable material to move from the at least third stable configuration to the second and/or the first stable configuration. A second actuator activation signal receiver can also be utilized in the methods, which upon receipt of a second actuator activation signal, initiates activation of the second actuator.

Several embodiments are specifically illustrated and/or described herein. However, it will be appreciated that modifications and variations of the disclosed embodiments are covered by the above teachings and within the purview of the appended claims without depending from the spirit and intended scope of the invention.

## Claims

1. A system capable of generating haptic feedback, comprising:
a. a multi-stable material configured in a first stable configuration; and
b. a first actuator coupled to the multi-stable material which when activated causes the multi-stable material to move from the first stable configuration to at least a second stable configuration and a third stable configuration, thereby generating haptic feedback.

2. The system of claim 1, further comprising a first actuator activation signal receiver, which upon receipt of a first actuator activation signal initiates activation of the first actuator.

3. The system of claim 1 or claim 2, wherein the multi-stable material comprises a metal or a polymer composite.

4. The system of any of claims 1-3, wherein the first actuator is a smart material actuator, including a smart material actuator comprising at least one of a shape memory material alloy (SMA), a shape memory polymer (SMP), an electroactive polymer (EAP), and a macro fiber composite (MFC) coupled to the multi-stable material.

5. The system of any of claims 1-4, wherein the first actuator is configured so that the movement of the multi-stable material is reversible.

6. The system of any of claims 1-5, wherein the system is associated with a structural material, preferably wherein the structural material is part of a wearable, including a textile.

7. The system of any of claims 1-6, wherein the first actuator coupled to the multi-stable material causes the multi-stable material to move from the third stable configuration to at least a fourth stable configuration.

8. The system of any of claims 1-7, wherein the actuator comprises two or more separate actuators coupled to the multi-stable material.

9. The system of any of claims 1-8, further comprising:
c. a second actuator coupled to the multi-stable material which when activated causes the multi-stable material to move from the at least third stable configuration to the second and/or the first stable configuration; and
d. a second actuator activation signal receiver, which upon receipt of a second actuator activation signal initiates activation of the second actuator.

10. A method of providing haptic feedback to a user, comprising:
a. receiving a haptic initiation signal from a source;
b. activating a first actuator coupled to a multi-stable material when the haptic initiation signal is received from the source; and
c. providing haptic feedback to the user by moving the multi-stable material from a first stable configuration to at least a second stable configuration and a third stable configuration upon activating the first actuator.

11. The method of claim 10, wherein the multi-stable material comprises a metal or a polymer composite, and wherein the first actuator is a smart material actuator, particularly wherein the smart material actuator is comprised of at least one of a shape memory material alloy (SMA), a shape memory polymer (SMP), an electroactive polymer (EAP), and a macro fiber composite (MFC) coupled to the multi-stable material.

12. The method of any of claims 10-11, wherein the first actuator is configured so that the movement of the multi-stable material is reversible.

13. The method of any of claims 10-12, wherein the first actuator coupled to the multi-stable material causes the multi-stable material to move from the third stable configuration to at least a fourth stable configuration.

14. The method of any of claims 10-13, wherein the first actuator comprises two or more separate actuators coupled to the multi-state material.

15. The method of claims 10-14, further comprising:
d. a second actuator coupled to the multi-stable material which when activated causes the multi-stable material to move from the at least third stable configuration to the second and/or the first stable configuration; and
e. a second actuator activation signal receiver, which upon receipt of a second actuator activation signal initiates activation of the second actuator, and wherein the haptic feedback is provided from a wearable.
